# EUROPÄISCHE PATENTSCHRIFT

(11) **EP 1 817 442 B1**
(45) Veröffentlichungstag und Bekanntmachung des Hinweises auf die Patenterteilung: **06.03.2019**
(21) Anmeldenummer: 05714203.6
(22) Anmeldetag: 28.11.2005
(51) Int. Cl.: B24C 1/06, C23C 14/58, C23C 16/56, C23C 30/00

(54) **WERKZEUG ZUR SPANABHEBENDEN BEARBEITUNG**
MACHINING TOOL
OUTIL POUR ENLEVER DES COPEAUX

(30) Priorität: 02.12.2004 AT 87204 U
(43) Veröffentlichungstag der Anmeldung: 15.08.2007
(73) Patentinhaber: CERATIZIT Austria Gesellschaft m.b.H., 6600 Reutte /Tirol (AT)
(72) Erfinder: WALLGRAM, Wolfgang, A-6600 Breitenwang (AT); SCHLEINKOFER, Uwe, A-6600 Reutte (AT); GIGL, Karl, A-6682 Vils (AT); THURNER, Josef, A-6611 Heiterwang (AT); SCHINTLMEISTER, Wilfried, A-6600 Reutte (AT)
(86) Internationale Anmeldenummer: PCT/AT2005/000478
(87) Internationale Veröffentlichungsnummer: WO 2006/058353

(56) Entgegenhaltungen:
- EP-A- 1 455 003
- EP-A2- 0 170 240
- EP-A2- 1 247 789
- DE-A1- 19 546 357
- DE-A1- 19 908 107
- US-A1- 2002 187 370
- DATABASE INSPEC [Online] THE INSTITUTION OF ELECTRICAL ENGINEERS, STEVENAGE, GB; 1997, TJONG S C ET AL: "Wear behaviour of an Al-12% Si alloy reinforced with a low volume fraction of SiC particles" XP002377096 Database accession no. 5897909 -& COMPOSITES SCIENCE AND TECHNOLOGY ELSEVIER UK, Bd. 57, Nr. 12, Februar 1997 (1997-02), Seiten 1551-1558, XP002377403 ISSN: 0266-3538

## Beschreibung

Die Erfindung betrifft ein Werkzeug zur spanabhebenden Bearbeitung aus einem Hartmetall-, Cermet- oder Keramik-Grundmaterial und einer auf diesem aufgebrachten ein- oder mehrlagigen Hartstoffbeschichtung.

Werkzeuge zur spanabhebenden Bearbeitung aus Hartmetall oder Cermet weisen in vielen speziellen Bearbeitungsfällen noch nicht die optimale Verschleißfestigkeit und Standzeit auf, so dass sie zusätzlich noch mit einer ein- oder mehrlagigen Hartstoffschicht versehen werden.
Beispiele für solche Hartstoffschichten sind karbidische, nitridische, karbonitridische, oxidische oder boridische Verbindungen verschiedener Metalle sowie nicht metallische, superharte Verbindungen.
Besonders häufig eingesetzte Hartstoffschichten sind beispielsweise Titannitrid, Titankarbonitrid und Aluminiumoxid, die allein oder auch in Kombination miteinander eingesetzt werden.
Zur Aufbringung dieser Hartstoffschichten werden in erster Linie chemische oder physikalische Dampfabscheidungsverfahren eingesetzt, die als CVD- und PVD-Verfahren bekannt sind.

In Abhängigkeit von den angewandten Beschichtungsverfahren kommt es aufgrund von herstellungsbedingten Oberflächenrauhigkeiten des zu beschichtenden Grundmaterials, aufgrund der Kristallinität der Hartstoffe und aufgrund verfahrensbedingter Schichtwachstumscharakteristiken sowie durch Verunreinigungen zu unerwünschten Mikrorauhigkeiten auf der freien Oberfläche der Beschichtung, welche die Verschleißfestigkeit und damit die Standzeit des Werkzeuges verschlechtern kann. Um diese Oberflächenrauhigkeiten möglichst zu reduzieren, und dadurch die Schneidkantenstabilität zu verbessern, wurden derartige Werkzeuge nach der Aufbringung der Hartstoffschicht zumindest an den freien Oberflächen bzw. Schneidkanten, an denen der abgearbeitete Span abläuft, zur Glättung einer Nachbehandlung unterzogen. Ein heute sehr häufig angewandtes Verfahren zur Nachbehandlung der Schichtoberfläche ist das Strahlverfahren. Bei diesem Verfahren werden in der Regel körnige Strahlmittel mit Korngrößen von etwa 1 - 2.000 µm, trocken mit Pressluft, oder nass als Suspension mit Überdruck auf die Oberfläche geschleudert und dadurch eine Glättung der Oberfläche erreicht. Als Strahlmittel wird häufig Korund verwendet.

Die DE 199 24 422 C2 beschreibt beispielsweise ein derartiges Strahlverfahren, bei dem als Strahlmittel insbesondere Al₂O₃ oder SiC mit Korngrößen von 1 - 100 µm verwendet werden und das Strahlmittel im Unterschied zu anderen Strahlverfahren eine kantige Kornform aufweist.

Nachteilig bei derartig angewandten Strahlverfahren ist es, dass ein reproduziertes kontrolliertes Abtragen von dünnen Deckschichten bzw. von Teilen der Hartstoffschichten oftmals nur schwer mit beträchtlichem Aufwand erreichbar ist. Darüber hinaus wird bei den bisher bekannten Strahlverfahren keine farbverändernde Deckschicht erreicht.

Eine andere Möglichkeit die Verschleißfestigkeit hartstoffbeschichteter Schneidwerkzeuge zu steigern liegt in der Aufbringung weicher Gleitschichten, an denen der ablaufende Span abgleitet, wodurch der Spanflächenverschleiß verringert wird. Gleichzeitig wird dadurch auch die Reibung zwischen der Freifläche des Werkzeuges und dem Werkstück verringert, wodurch auch im Freiflächenbereich der Verschleiß reduziert wird.

Die WO 96/30148 beschreibt beispielsweise ein Schneidwerkzeug, bei dem als entsprechende Gleitschichten Sulfide, Selenide, Telluride oder Mischverbindungen davon aufgebracht werden.

Der Nachteil bei derartigen Schichten liegt darin, dass sie zumeist nur eine geringe thermische, chemische und mechanische Stabilität gegen Abrieb sowie teilweise eine unzureichende Schichthaftung bei den bei der Zerspanung auftretenden hohen thermischen, chemischen und mechanischen Beanspruchungen aufweisen. Darüber hinaus wird auch mit derartigen Schichten keine Änderung der Farbgebung und damit eine eventuelle Verbesserung der Verschleißerkennung erreicht.

US 2002/0187370 A1 beschreibt ein beschichtetes Schneidwerkzeug mit einer Hartstoffbeschichtung auf einem Substrat nach dem Oberbegriff von Anspruch 1 und ein Verfahren nach dem Oberbegriff von Anspruch 9. Das Substrat ist durch eine Binderphase, die eine oder mehrere Arten von Eisen-Gruppen-Metallen aufweist, und eine Hartphase, die Karbide, Nitride und Oxide der Elemente der Gruppen IVa, Va und VIa des Periodensystems aufweisen kann, gebildet. Die Hartstoffbeschichtung ist teilweise geglättet, um einen niedrige Oberflächenrauigkeit zu erzielen.

EP1 455 003 A2 beschreibt einen Schneideinsatz zum Drehen von Stahl mit einem Hartmetallkörper und einer mehrlagigen, nachbehandelten Beschichtung. Die Beschichtung weist ein erstes, inneres Schichtsystem aus TiCₓN_{y}O_{z} und ein zweites Mehrlagen-System aus alternierenden Al₂O₃- und TiCₓN_{y}O_{z}-Schichten auf DE 19908107 beschreibt ein Verfahren zur Erzeugung einer verschleißfesten Oberfläche mit einem mehrlagigen Beschichtung aus Aluminium-Bronze, die direkt auf dem Substrat aufgeschmolzen wird. EP0170240 beschreibt ein Verfahren zum Erzeugen einer metallischen Beschichtung durch Strahlen ein Substrat mit einem Fe-Zn basierten Pulver.

Aufgabe der vorliegenden Erfindung ist es, ein Werkzeug zur spanabhebenden Bearbeitung zu schaffen, das gegenüber bisher bekannten, nachbehandelten Werkzeugen eine verbesserte Verschleißfestigkeit und damit höhere Standzeit aufweist, das wirtschaftlich und kostengünstig herstellbar ist und bei dem vielfach eine verbesserte Verschleißerkennung gewährleistet ist.

Erfindungsgemäß wird dies durch ein Werkzeug nach Anspruch 1 und durch ein Verfahren zur Herstellung eines Werkzeugs nach Anspruch 8 gelöst.

Völlig überraschend hat sich herausgestellt, dass durch die erfindungsgemäße Nachbehandlung ein verbesserter Spanfluss erreicht wird, so dass es insbesondere beim Trockendrehen zu keiner Beschädigung der Schneidkanten und damit zu einer deutlichen Steigerung der möglichen Einsatzzeit des Schneidwerkzeuges kommt.

Als vorteilhafter Nebeneffekt kommt dabei hinzu, dass die Farbgebung des Schneidwerkzeuges durch den metallisch glänzenden Charakter verändert wird und dadurch die Verschleißerkennung, insbesondere bei Schneidwerkzeugen die mit einer dunkelgrauen bis dunkelbraunen oder schwarzen Aluminiumoxidschicht als oberste Hartstoffschicht versehen sind, deutlich erleichtert wird.

Der erfindungsgemäße Überzug lässt sich an allen bekannten Hartstoffschichten, wie bei Schichten aus Karbiden, Nitriden, Karbonitriden, Boriden der Metalle der Gruppe IVa- VIa des Periodensystems, wie z.B. Ti, Zr, Hf und deren Kombinationen sowie deren Verbindung mit Zusätzen von z.B. Sauerstoff und/oder Bor, weiters bei Schichten aus TiAIN sowie bei Schichten die ganz oder teilweise aus Aluminiumoxid und/oder Zirkonoxid bestehen, vorteilhaft anwenden.

Hinsichtlich einer vorteilhaften Dicke des erfindungsgemäßen Überzuges haben sich Schichtstärken im Bereich von 0,05 - 50 µm, vorzugsweise im Bereich von 0,1 - 10 µm bewährt.

Die Aufbringung des erfindungsgemäßen Überzuges ist insbesondere dann von Vorteil, wenn die oberste Lage der Hartstoffbeschichtung aus einer Aluminiumoxid enthaltenden Schicht besteht, da durch die hohe Lichtabsorption des Aluminiumoxids die Verschleißerkennung besonders problematisch ist.

Bei Hartstoffbeschichtungen, bei denen die oberste Lage Titankarbid, Titankarbonitrid, Titannitrid oder Titandiborid enthält, werden durch die Aufbringung des erfindungsgemäßen zusätzlichen Überzuges besonders gute Ergebnisse hinsichtlich Verbesserung der Verschleißfestigkeit erreicht.

Als besonders vorteilhafte Materialien für die erfindungsgemäßen Überzugsschichten haben sich Aluminium bzw. Aluminium-Basislegierungen dort insbesondere eine Aluminium-Basislegierung mit 12 Gew.% Silizium sowie Messing und Bronzelegierungen bewährt, die einerseits ausgezeichnete Gleit - bzw. Schmiereigenschaften aufweisen und andererseits die Unebenheiten der obersten Lage der Hartstoffschicht hervorragend einebnen und damit das Verschleißverhalten des erfindungsgemäß behandelten Werkzeuges deutlich verbessern. Zusätzlich ergeben sich spezifische Farbänderungen des Werkzeuges, welche durch die hohe Lichtreflexion eine besonders klare Verschleißerkennung am Werkzeug ermöglichen.

Insbesondere zweckmäßig ist es, die Aufbringung eines erfindungsgemäßen Überzuges bei Wendeschneidplatten vorzunehmen. In diesem Fall ist es besonders kostengünstig und einfach, die Aufbringung des erfindungsgemäßen Überzuges durch eine Strahlbehandlung unter Verwendung eines Strahlmittels aus dem gewünschten Überzugsmetall vorzunehmen.

Von Vorteil kann es auch sein, die oberste Hartstoffschicht vor der Aufbringung des erfindungsgemäßen Überzuges einer Strahlbehandlung mit einem nichtmetallischen Strahlmittel, wie z.B. Korund, zu unterziehen. Dadurch wird die Oberfläche bereits vorgeglättet und die Aufbringung des erfindungsgemäßen Überzuges kann dann in geringeren Schichtstärken erfolgen.

Neben dieser besonders vorteilhaften Vorbehandlung zum Glätten der obersten Hartstoffschicht lassen sich selbstverständlich auch andere bekannte Verfahren, wie z.B. mechanisches Bürsten, Gleitschleifen, etc., einsetzen.

Im Folgenden wird die Erfindung an Hand von Herstellungsbeispielen näher erläutert.

### Beispiel 1

Mehrlagig mit einer 18 µm dicken Ti(C,N)/Al₂O₃-Mischoxid/Ti(C,N,B)/TiN Hartstoffbeschichtung beschichtete Wendeschneidplatten aus einem Hartmetallsubstrat mit 5,8 % Co, 1 % TiC, 0,8 % ZrC, 0,2 % ZrN, 4,1 % TaC, Rest WC, wurden in einer Strahlanlage mit einem Gries aus einer Aluminium-Siliziumlegierung mit 12 Gew.% Silizium mit einer Körnung von 100 - 315 µm mit einem Druck von 2,5 bar 1 Minute lang gestrahlt.

Die Wendeschneidplatten erhielten dadurch einen dünnen, metallisch glänzenden Überzug.

Diese erfindungsgemäß mit einer Al-Si-Legierung beschichteten Wendeschneidplatten wurden in einem Zerspanungsversuch zur Drehbearbeitung von Baustahl Ck45, mit einer Festigkeit von 700 N/mm² mit einer Schnittgeschwindigkeit von 300 m/min bei einem Vorschub von 0,25 mm/U und einer Spantiefe von 2 mm ohne Kühlmittel eingesetzt. Für Vergleichszwecke wurden für eine Drehbearbeitung unter den gleichen Bedingungen die gleichen hartstoffbeschichteten Wendeschneidplatten jedoch ohne erfindungsgemäßen Überzug eingesetzt.

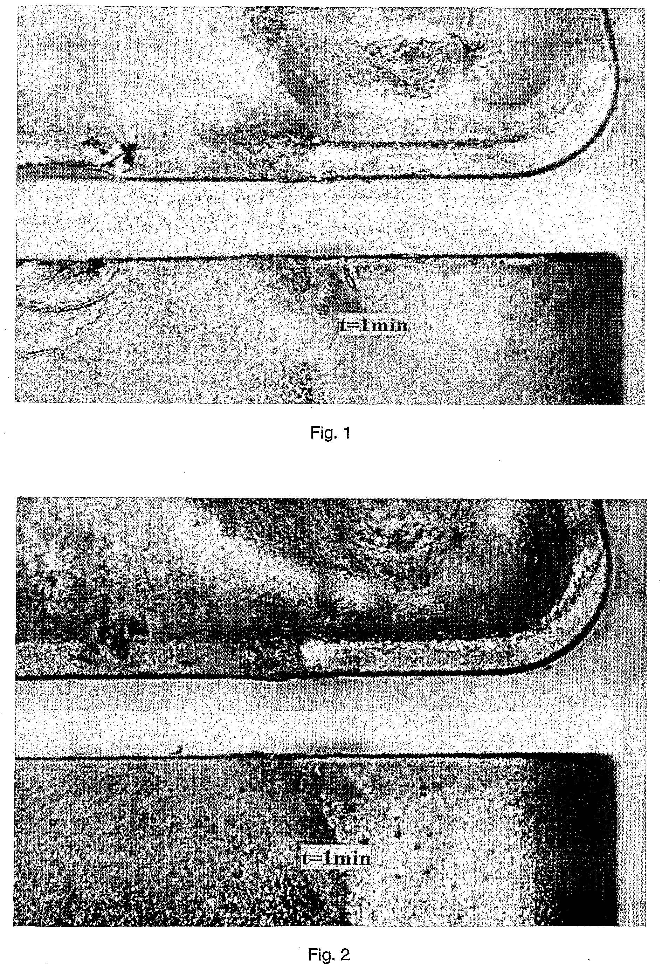

Dabei stellte sich heraus, dass bei den nicht erfindungsgemäß überzogenen Wendeschneidplatten bereits nach 1 Minute Drehdauer die Schneidkanten unmittelbar neben den Verschleißmarken beschädigt waren. Diese Beschädigungen sind durch die Aufnahme der Spanfläche und der Freifläche einer Wendeschneidplatte in Figur 1 beispielhaft dargestellt.

Bei den erfindungsgemäß überzogenen Wendeschneidplatten konnten nach derselben Drehdauer von 1 Minute keinerlei Beschädigungen an der Schneidkante festgestellt werden, was in Figur 2 beispielhaft an einer Wendeschneidplatte dargestellt ist.

Daraus ist ersichtlich, dass die Standzeit der Schneidkante durch den erfindungsgemäßen metallischen Überzug gravierend verlängert wird.

### Beispiel 2

Wendeschneidplatten mit dem gleichen Hartmetallsubstrat / Hartstoffschicht Aufbau wie in Beispiel 1 wurden in einer Strahlanlage mit einem Gries aus Messing mit einer Körnung von 100 - 315 µm mit einem Druck von 2,5 bar 1 Minute lang gestrahlt.

Diese erfindungsgemäß mit Messing beschichteten Wendeschneidplatten wurden wiederum zusammen mit gleichartigen Wendeschneidplatten ohne erfindungsgemäßen Messing-Überzug demselben Zerspanungsversuch wie in Beispiel 1 unterzogen und miteinander verglichen.

Die nicht erfindungsgemäß beschichteten Wendeschneidplatten waren bereits nach 1 Minute Drehdauer an den Schneidkanten durch den ablaufenden Span beschädigt, ähnlich wie es bereits beispielhaft an einer Wendeschneidplatte gemäß Beispiel 1 in Figur 1 dargestellt ist.

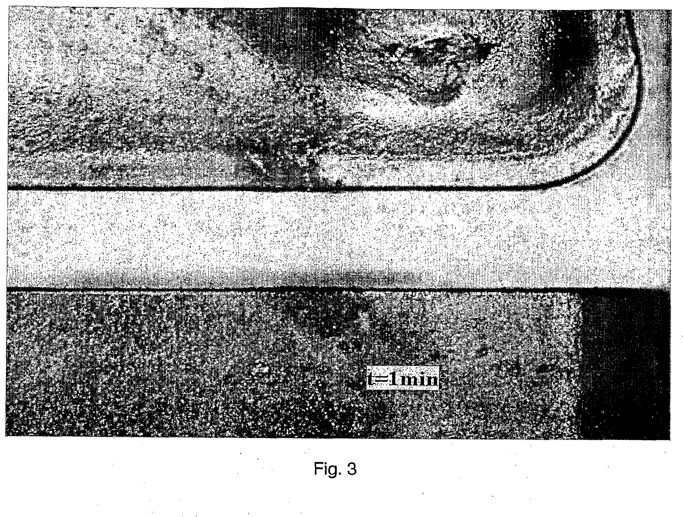

Die erfindungsgemäß mit Messing überzogenen Wendeschneidplatten wiesen nach derselben Drehdauer keinerlei Beschädigungen an den Schneidkanten auf. Dies ist beispielhaft an einer Wendeschneidplatte in Figur 3 dargestellt.

### Beispiel 3

Die gleichen Wendeschneidplatten wie in Beispiel 1, einmal erfindungsgemäß beschichtet und einmal ohne zusätzlichen Überzug, wurden in einem zweiten Zerspanungsversuch zur Drehbearbeitung von Stahl Ck45, mit einer Festigkeit von 700 N/mm² mit einer Schnittgeschwindigkeit von 320 m/min und einem Vorschub von 0,3 mm/U bei einer Spantiefe von 2 mm unter Verwendung einer Kühlemulsion, eingesetzt.

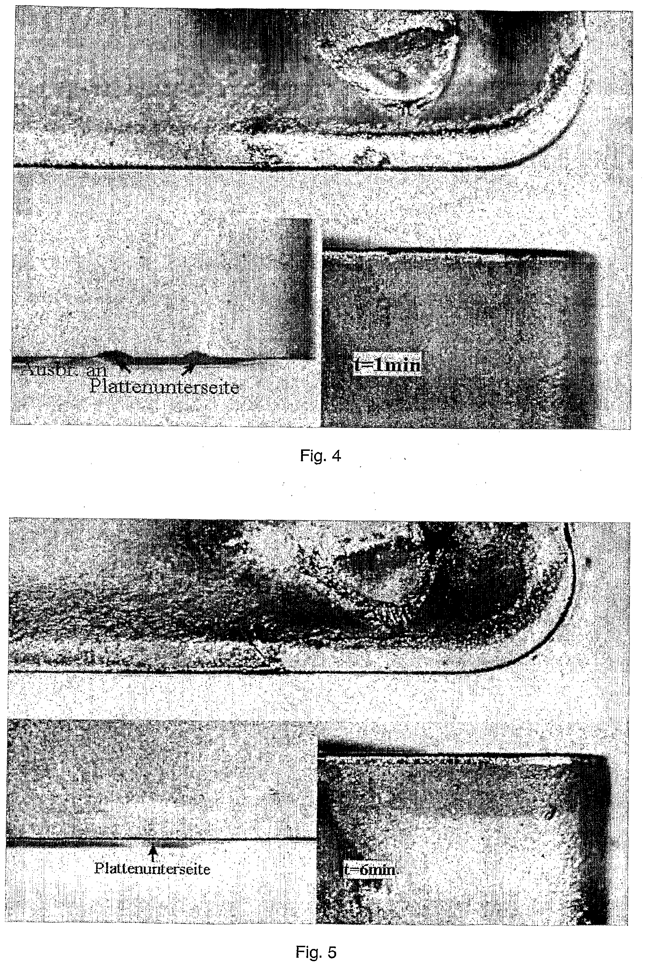

Dabei stellte sich heraus, dass bereits nach 1 Minute Drehdauer die nicht erfindungsgemäß beschichteten Wendeschneidplatten an der Unterseite durch den ablaufenden Span derart beschädigt waren, dass die Schneidkanten an dieser Stelle der Wendeschneidplatte nicht mehr zum Drehen verwendet werden konnten. Diese Beschädigungen sind durch die Aufnahme der Freifläche einer Wendeschneidplatte in Figur 4 beispielhaft dargestellt.

Bei den erfindungsgemäß überzogenen Wendeschneidplatten waren selbst bei einer Drehdauer von 6 Minuten noch keinerlei Beschädigungen an der Unterseite durch den ablaufenden Span zu erkennen, was beispielhaft an der Aufnahme einer Wendeschneidplatte in Figur 5 dargestellt ist.

Aus diesen Beispielen ist ersichtlich, dass durch die erfindungsgemäße Behandlung der hartstoffbeschichteten Werkzeuge deren Einsatzfähigkeit wesentlich gesteigert werden kann.

### Beispiel 4

Wendeschneidplatten aus einem Hartmetallsubstrat mit 6 % Co, Rest WC wurden mit einer 16 µm dicken mehrlagigen Hartstoffbeschichtung aus Ti(C,N)/Ti(C,N,B)/Al₂O₃-Mischoxid beschichtet. Anschließend wurde ein Teil der Wendeschneidplatten mit einem erfindungsgemäßen Überzug aus einer Al-Si-Legierung wie in Beispiel 1 unterzogen.

In einem vergleichenden Zerspanungstest wurden beide Wendeschneidplattenvarianten zur Drehbearbeitung von Eisenguss GG25, Härte 190 HB, bei einer Schnittgeschwindigkeit von 350 m/min, einem Vorschub von 0,3 mm/U, einer Spantiefe von 2 mm/U, ohne Verwendung einer Kühlemulsion eingesetzt.

Die Wendeschneidplatten mit dem erfindungsgemäßen Überzug aus der Al-Si-Legierung wiesen dabei im Schnitt eine um 28 % höhere Standzeit bis zum Erreichen der maximal zulässigen Verschleißmarkenbreite von 0,3 mm auf.

### Beispiel 5

Wendeschneidplatten aus einem Hartmetallsubstrat mit 6 % Co, 2 % TaC, Rest WC, wurden wie in Beispiel 4 beschichtet und ein Teil der Platten mit einem erfindungsgemäßen Überzug aus einer Al-Si-Legierung wie in Beispiel 1 versehen. Beide Wendeschneidplattenvarianten wurden demselben vergleichenden Zerspanungstest wie in Beispiel 4 unterzogen.

Die Wendeschneidplatten mit dem erfindungsgemäßen Al-Si-Überzug wiesen im Schnitt eine um 21% höhere Standzeit bis zum Erreichen der maximal zulässigen Verschleißmarkenbreite von 0,3 mm auf.

## Patentansprüche

1. Wendeschneidplatte zur spanabhebenden Bearbeitung aus einem Hartmetall-, Cermet- oder Keramik-Grundmaterial und einer auf diesem aufgebrachten ein- oder mehrlagigen Hartstoffbeschichtung mit zumindest einer Schicht aus der Gruppe von Karbiden, Nitriden, Karbonitriden, Boriden der Metalle der Gruppe IVa-VIa des Periodensystems sowie deren Verbindung mit Zusätzen von Sauerstoff und/oder Bor, aus TiAIN oder aus Aluminiumoxid und/oder Zirkonoxid,
**dadurch gekennzeichnet,**
**dass** auf der Hartstoffbeschichtung ein zusätzlicher metallischer Überzug aus einem oder mehreren Metallen aus der Gruppe Aluminium, Kupfer, Zink, Zinn oder aus Basislegierungen dieser Metalle aufgebracht ist.

2. Wendeschneidplatte nach Anspruch 1, **dadurch gekennzeichnet, dass** die Schichtstärke des zusätzlichen Überzuges im Bereich von 0,05 - 50 µm, vorzugsweise von
0,1 - 10 µm liegt.

3. Wendeschneidplatte nach Anspruch 1 oder 2, **dadurch gekennzeichnet, dass** die oberste Lage der Hartstoffbeschichtung aus einer Aluminiumoxid enthaltenden Schicht besteht.

4. Wendeschneidplatte nach Anspruch 1 oder 2, **dadurch gekennzeichnet, dass** die oberste Lage der Hartstoffbeschichtung aus einer Titankarbid, Titankarbonitrid, Titannitrid oder Titandiborid enthaltenden Schicht besteht.

5. Wendeschneidplatte nach einem der Ansprüche 1 bis 4, **dadurch gekennzeichnet, dass** der zusätzliche Überzug aus Aluminium oder aus einer Basislegierung des Aluminiums besteht.

6. Wendeschneidplatte nach Anspruch 5, **dadurch gekennzeichnet, dass** der zusätzliche Überzug aus einer Aluminium-Basislegierung mit 12 Gew.% Silizium besteht.

7. Wendeschneidplatte nach einem der Ansprüche 1 bis 4, **dadurch gekennzeichnet, dass** der zusätzliche Überzug aus einer Messing- oder Bronzelegierung besteht.

8. Verfahren zur Herstellung einer Wendeschneidplatte zur spanabhebenden Bearbeitung nach einem der Ansprüche 1 bis 7 mit den Schritten:
Bereitstellen einer Wendeschneidplatte zur spanabhebenden Bearbeitung aus einem Hartmetall-, Cermet- oder Keramik-Grundmaterial und einer auf diesem aufgebrachten ein- oder mehrlagigen Hartstoffbeschichtung mit zumindest einer Schicht aus der Gruppe von Karbiden, Nitriden, Karbonitriden, Boriden der Metalle der Gruppe IVa-VIa des Periodensystems sowie deren Verbindung mit Zusätzen von Sauerstoff und/oder Bor, aus TiAIN oder aus Aluminiumoxid und/oder Zirkonoxid;
**gekennzeichnet durch**:
Aufbringung eines zusätzlichen metallischen Überzuges aus einem oder mehreren Metallen aus der Gruppe Aluminium, Kupfer, Zink, Zinn oder aus Basislegierungen dieser Metalle durch eine Strahlbehandlung der obersten Hartstoffschicht, wobei zum Strahlen körnige Strahlmittel mit der Zusammensetzung des zusätzlichen metallischen Überzuges eingesetzt werden.

9. nach Anspruch 8 **dadurch gekennzeichnet, dass** die oberste Hartstoffschicht vor der Aufbringung des zusätzlichen Überzuges einer Strahlbehandlung mit einem nichtmetallischen Strahlmittel, wie Korund, unterzogen wird.

## Claims

1. Indexable cutting insert for machining made from a hard-metal, cermet or ceramic base material and a single-layer or multi-layer hard material coating applied to said base material, the hard material coating having at least one layer from the group of carbides, nitrides, carbonitrides, borides of the metals of group IVa-VIa of the periodic table as well as combinations thereof with additives of oxygen and/or boron, from TiAlN or from aluminium oxide and/or zirconium oxide,
**characterized in that** an additional metallic coating of one or more metals from the group of aluminium, copper, zinc, tin or from base alloys of these metals is applied to the hard material coating.

2. Indexable cutting insert according to Claim 1, **characterized in that** the layer thickness of the additional coating is in the range of 0.05-50 µm, preferably 0.1-10 µm.

3. Indexable cutting insert according to Claim 1 or 2, **characterized in that** the uppermost layer of the hard material coating consists of a layer containing aluminium oxide.

4. Indexable cutting insert according to Claim 1 or 2, **characterized in that** the uppermost layer of the hard material coating consists of a layer containing titanium carbide, titanium carbonitride, titanium nitride or titanium diboride.

5. Indexable cutting insert according to one of Claims 1 to 4, **characterized in that** the additional coating consists of aluminium or a base alloy of aluminium.

6. Indexable cutting insert according to Claim 5, **characterized in that** the additional coating consists of an aluminium base alloy with 12% by weight silicon.

7. Indexable cutting insert according to one of Claims 1 to 4, **characterized in that** the additional coating consists of a brass alloy or bronze alloy.

8. Method for producing an indexable cutting insert for machining according to one of Claims 1 to 7 with the steps:
providing an indexable cutting insert for machining made from a hard-metal, cermet or ceramic base material and a single-layer or multi-layer hard material coating applied to said base material, said hard material coating having at least one layer from the group of carbides, nitrides, carbonitrides, borides of the metals of group IVa-VIa of the periodic table as well as combinations thereof with additives of oxygen and/or boron, from TiAlN or from aluminium oxide and/or zirconium oxide; **characterized by**
applying an additional metallic coating from one or more metals from the group of aluminium, copper, zinc, tin or from base alloys of these metals by blasting treatment of the uppermost hard material layer, wherein granular blasting medium having the composition of the additional metallic coating is used for the blasting.

9. Method according to claim 8, **characterized in that** the uppermost hard material layer is subjected to a blasting treatment with a nonmetallic abrasive, such as corundum, before the application of the additional coating.

## Revendications

1. Plaquette de coupe indexable pour l'usinage avec enlèvement de copeaux en un matériau de base en métal dur, en cermet ou en céramique et un recouvrement en une ou plusieurs couche(s) en matériau dur déposé sur celle-ci avec au moins une couche du groupe des carbures, nitrures, carbonitrures, borures des métaux du groupe IVa - VIa du système périodique ainsi que leur composé avec des ajouts d'oxygène et/ou de bore, en TiAlN ou en oxyde d'aluminium et/ou en oxyde de zirconium,
**caractérisée en ce qu'**un revêtement métallique supplémentaire en un métal ou plusieurs métaux du groupe aluminium, cuivre, zinc, étain ou des alliages à base de ces métaux est déposé sur le recouvrement en matériau dur.

2. Plaquette de coupe indexable selon la revendication 1, **caractérisée en ce que** l'épaisseur de couche du revêtement supplémentaire se situe dans la plage de 0,05 à 50 µm, de préférence de 0,1 à 10 µm.

3. Plaquette de coupe indexable selon la revendication 1 ou 2, **caractérisée en ce que** la couche supérieure du recouvrement en matériau dur est constituée par une couche contenant de l'oxyde d'aluminium.

4. Plaquette de coupe indexable selon la revendication 1 ou 2, **caractérisée en ce que** la couche supérieure du recouvrement en matériau dur est constituée par une couche contenant du carbure de titane, du carbonitrure de titane, du nitrure de titane ou du borure de titane.

5. Plaquette de coupe indexable selon l'une quelconque des revendications 1 à 4, **caractérisée en ce que** le revêtement supplémentaire se compose d'aluminium ou d'un alliage à base d'aluminium.

6. Plaquette de coupe indexable selon la revendication 5, **caractérisée en ce que** le revêtement supplémentaire se compose d'un alliage à base d'aluminium avec 12 % en poids de silicium.

7. Plaquette de coupe indexable selon l'une quelconque des revendications 1 à 4, **caractérisée en ce que** le revêtement supplémentaire se compose d'un alliage de laiton ou de bronze.

8. Procédé de fabrication d'une plaquette de coupe indexable pour l'usinage avec enlèvement de copeaux selon l'une quelconque des revendications 1 à 7, présentant les étapes suivantes:
préparer une plaquette de coupe indexable pour l'usinage avec enlèvement de copeaux en un matériau de base en métal dur, en cermet ou en céramique et un recouvrement en une ou plusieurs couche(s) en matériau dur déposé sur celle-ci avec au moins une couche du groupe des carbures, nitrures, carbonitrures, borures des métaux du groupe IVa - VIa du système périodique ainsi que leur composé avec des ajouts d'oxygène et/ou de bore, en TiAlN ou en oxyde d'aluminium et/ou en oxyde de zirconium;
**caractérisé par** le dépôt d'un revêtement métallique supplémentaire en un métal ou plusieurs métaux du groupe aluminium, cuivre, zinc, étain ou des alliages à base de ces métaux par un traitement de grenaillage de la couche supérieure de matériau dur, dans lequel on utilise pour le grenaillage des agents de grenaillage en grains ayant la composition du revêtement métallique supplémentaire.

9. Procédé selon la revendication 8, **caractérisé en ce que** l'on soumet la couche supérieure de matériau dur à un traitement de grenaillage avec un agent de grenaillage non métallique, comme le corindon, avant le dépôt du revêtement supplémentaire.
